# EUROPEAN PATENT APPLICATION

(11) **EP 4 682 946 A1**
(43) Date of publication of application: **21.01.2026**
(21) Application number: 23928516.6
(22) Date of filing: 17.03.2023
(51) Int. Cl.: H01L 21/677, H01L 21/67

(54) **CHIP HOLDING TOOL, CHIP HOLDING DEVICE, AND DEVICE FOR MANUFACTURING SEMICONDUCTOR DEVICE**

(71) Applicant: Yamaha Robotics Co., Ltd., Musashimurayama-shi, Tokyo 208-8585 (JP); TOKYO UNIVERSITY OF SCIENCE FOUNDATION, Tokyo 162-8601 (JP)
(72) Inventor: KIKUCHI Hiroshi, Musashimurayama-shi, Tokyo 208-8585 (JP); LI Jin, Musashimurayama-shi, Tokyo 208-8585 (JP); MIYATAKE Masaaki, Tokyo 162-8601 (JP)
(74) Representative: Becker, Eberhard
(86) International application number: PCT/JP2023/010615
(87) International publication number: WO 2024/194931

(57) **Abstract**

A chip holding tool (12) comprises: a holding surface (24) for holding a semiconductor chip (100) in a non-contact manner; a suction path (33) for providing negative pressure at the holding surface (24) and drawing the semiconductor chip (100) by suction; and an ultrasonic generator (14) for providing ultrasonic oscillation to the holding surface (24), wherein the size of the outer shape of the holding surface (24) is larger than the size of the outer shape of the semiconductor chip (100). A positioning groove (36) having a shape conforming to at least a portion of the outer shape of the semiconductor chip (100) is formed in the holding surface (24).

## Description

### Technical Field

This specification discloses a technology for holding a semiconductor chip in a non-contact manner using ultrasonic waves.

### Background Art

In order to realize further miniaturization and higher density of semiconductor devices, chip holding tools for holding semiconductor chips in a non-contact manner have been demanded in recent years. To meet such demands, chip holding tools that hold semiconductor chips in a non-contact manner have been proposed in some cases.

Some known chip holding tools use a Bernoulli chuck. However, in the case of a Bernoulli chuck, movement in the surface direction of a semiconductor chip held in a non-contact manner cannot be regulated. Therefore, chip holding tools using a Bernoulli chuck are often provided with a guide member on the holding surface of the chip for regulating movement in the surface direction of the chip.

However, providing the guide member imposes a risk that the end portion of the semiconductor chip may come into contact with the guide member, leading to chipping of the semiconductor chip.

### Related Art Document

### Patent Document

Patent Document 1: Japanese Patent Application Laid-Open No. 2006-73654

### SUMMARY OF INVENTION

### Problem to be Solved by the Invention

Therefore, in some cases, technologies for holding a workpiece such as IC chip in a non-contact manner using ultrasonic waves have been proposed (for example, Patent Document 1, etc.). The ultrasonic squeeze effect produced by application of ultrasonic waves also generates a force for holding the workpiece in the surface direction, which makes it possible to omit the guide member. However, for the technology of Patent Document 1, there is room for further improvement in terms of positioning accuracy in the surface direction.

Therefore, this specification discloses a chip holding tool, a chip holding device, and a device for manufacturing a semiconductor device that are capable of appropriately positioning a semiconductor chip without contacting the semiconductor chip.

### Means for Solving the Problem

A chip holding tool disclosed in this specification includes a holding surface holding a semiconductor chip in a non-contact manner; a suction path applying negative pressure to the holding surface to draw the semiconductor chip by suction; and an oscillation generation part applying ultrasonic oscillation to the holding surface, in which a size of an outer shape of the holding surface is larger than a size of an outer shape of the semiconductor chip.

In this case, a positioning groove having a shape conforming to at least a portion of the outer shape of the semiconductor chip may be formed on the holding surface.

Furthermore, the oscillation generation part may include a horn portion that transmits ultrasonic oscillation, and the chip holding tool may further include a plate-shaped holding portion which is connected to an end of the horn portion, and an end surface of which functions as the holding surface. The holding portion may include a central portion that overlaps with the horn portion in an axial direction, and a flange portion that extends radially outward from the central portion and is thinner than the central portion.

Further, at least a portion of the positioning groove may penetrate through the flange portion in a thickness direction.

Further, in a case of applying ultrasonic oscillation to the holding surface, an oscillation amplitude of an outer portion with respect to the positioning groove may be greater than an oscillation amplitude of an inner portion with respect to the positioning groove.

In this case, the semiconductor chip may be self-aligned to be positioned inside the positioning groove by receiving the oscillation amplitude of the outer portion with respect to the positioning groove.

Another chip holding tool disclosed in this specification is a chip holding tool that includes a holding surface holding a semiconductor chip in a non-contact manner; a suction path applying negative pressure to the holding surface to draw the semiconductor chip by suction; and an oscillation generation part applying ultrasonic oscillation to the holding surface, in which the suction path has a suction hole formed on the holding surface and communicating with a suction source, and the holding surface is formed with an airflow formation groove that connects to the suction hole and extends in a surface direction.

In this case, the airflow formation groove may be formed only in an area that is inside an outer shape of the semiconductor chip.

Further, the airflow formation groove may include one or more radial portions that extend in a surface direction from the suction hole. In this case, the airflow formation groove may further include one or more peripheral portions that directly connect to the radial portion while not passing through the suction hole. In addition, the peripheral portion may be a closed shape that surrounds the suction hole and connects all of the one or more radial portions.

Further, a depth of the airflow formation groove may be greater than a floating amount of the semiconductor chip from the holding surface and less than 50 times the floating amount.

A chip holding device disclosed in this specification is a chip holding device that holds a semiconductor chip in a non-contact manner, and includes a chip holding tool holding the semiconductor chip in a non-contact manner; an ultrasonic generation part applying ultrasonic oscillation to a holding surface that is an end surface of the holding tool; a suction path applying negative pressure to a suction hole formed on the holding surface to generate a suction force; and a controller controlling ultrasonic energy or the suction force so that a holding force generated by the ultrasonic oscillation, the suction force, and gravity acting on the semiconductor chip are balanced in a state where the semiconductor chip is separated from the holding surface.

In this case, the controller may change a magnitude of at least one of the ultrasonic energy and the suction force applied to the holding surface between a case of moving a position of the holding surface and a case of keeping the position stationary.

Further, the controller may increase at least one of the ultrasonic energy and the suction force in a case of moving the holding surface compared to a case of keeping the holding surface stationary.

Another chip holding device disclosed in this specification is a chip holding device that holds a semiconductor chip in a non-contact manner, and includes a chip holding tool holding the semiconductor chip in a non-contact manner; an ultrasonic generation part applying ultrasonic oscillation to a holding surface that is an end surface of the chip holding tool; a suction path applying negative pressure to a suction hole formed on the holding surface to generate a suction force; a controller controlling driving of the ultrasonic generation part and a suction source so that a holding force generated by the ultrasonic oscillation, the suction force, and gravity acting on the semiconductor chip are balanced in a state where the semiconductor chip is separated from the holding surface; and at least one of a surface processing device that applies processing to a surface of the semiconductor chip held in a non-contact manner by the holding surface, and an inspection device that inspects the surface.

A device for manufacturing a semiconductor device disclosed in this specification includes a chip holding tool holding a semiconductor chip in a non-contact manner; an ultrasonic generation part applying ultrasonic oscillation to a holding surface that is an end surface of the chip holding tool; a suction path applying negative pressure to a suction hole formed on the holding surface to generate a suction force; and a controller controlling driving of the ultrasonic generation part and a suction source so that a holding force generated by the ultrasonic oscillation, the suction force, and gravity acting on the semiconductor chip are balanced in a state where the semiconductor chip is separated from the holding surface, in which a size of an outer shape of the holding surface is larger than a size of an outer shape of the semiconductor chip.

In this case, the chip holding tool may function as a pickup collet that receives the semiconductor chip from a chip supply source, then flips 180 degrees while maintaining a state of holding the semiconductor chip in a non-contact manner, and transfers the semiconductor chip to a bonding tool.

Further, the device for manufacturing the semiconductor device may directly bond the semiconductor chip to a substrate.

### Effects of the Invention

According to the chip holding tool disclosed in this specification, the semiconductor chip can be appropriately positioned with respect to the holding tool without contacting the semiconductor chip.

### BRIEF DESCRIPTION OF THE DRAWINGS

[FIG. 1] is a view showing the configuration of the chip holding device.
[FIG. 2] is an axial view of the holding surface.
[FIG. 3] is an image view showing action of the positioning groove.
[FIG. 4] is an image view showing action of the airflow formation groove.
[FIG. 5A] is a view showing an example of the groove formed on the holding surface.
[FIG. 5B] is a view showing another example of the groove formed on the holding surface.
[FIG. 5C] is a view showing another example of the groove formed on the holding surface.
[FIG. 6A] is a view showing another example of the groove formed on the holding surface.
[FIG. 6B] is a view showing another example of the groove formed on the holding surface.
[FIG. 6C] is a view showing another example of the groove formed on the holding surface.
[FIG. 7] is a view showing the configuration of another chip holding device.
[FIG. 8A] is a view showing the processing device that performs the plasma process.
[FIG. 8B] is a view showing the processing device that performs the cleaning process.
[FIG. 9A] is a view showing the inspection device that inspects the edge of the semiconductor chip.
[FIG. 9B] is a view showing the inspection device that inspects the appearance of the semiconductor chip.
[FIG. 10] is a view showing an example of the manufacturing device that has the chip holding device.

### DESCRIPTION OF THE EMBODIMENTS

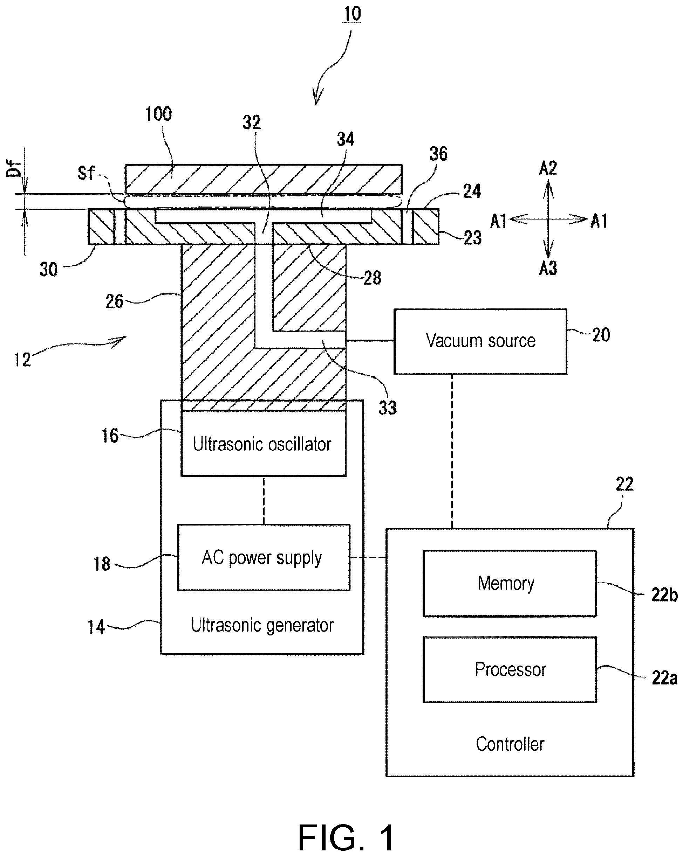

Hereinafter, the configuration of a chip holding device 10 will be described with reference to the drawings. FIG. 1 is a view showing the configuration of the chip holding device 10. This chip holding device 10 is a device that holds and transports a semiconductor chip 100 in a non-contact manner, and is incorporated into, for example, a manufacturing device or an inspection device for a semiconductor device.

As shown in FIG. 1, the chip holding device 10 includes a chip holding tool 12, an ultrasonic generator 14, a vacuum source 20, and a controller 22. The chip holding tool 12 holds the semiconductor chip 100 in a non-contact manner. The chip holding tool 12 has a substantially plate-shaped holding portion 23, and a horn portion 26 extending in the axial direction from the holding portion 23. An end surface of the holding portion 23 functions as a holding surface 24 for holding the semiconductor chip 100. An airflow formation groove 34 and a positioning groove 36 are formed on this holding surface 24, and the two types of grooves 34 and 36 will be described later. The chip holding tool 12 also has a suction path 33 that communicates with the vacuum source 20 described later, and applies negative pressure to the holding surface 24 to draw the semiconductor chip 100 by suction. A suction hole 32, which is an end of this suction path 33, is formed at the center of the holding surface 24.

The position and posture of the chip holding tool 12 can be changed as appropriate. Accordingly, in FIG. 1, the holding surface 24 faces upward, but depending on the usage situation of the chip holding tool 12, the chip holding tool 12 may take a posture with the holding surface 24 in parallel to the vertical direction, or a posture with the holding surface 24 facing downward. Then, the chip holding tool 12 can continue to hold the semiconductor chip 100 in a non-contact manner even with the posture changed.

From the back side of the holding surface 24 (that is, the opposite side from the semiconductor chip 100), the horn portion 26 extends in the axial direction. The horn portion 26 is a portion that transmits ultrasonic oscillation generated by the ultrasonic generator 14 to the holding surface 24. Inside this horn portion 26, the suction path 33 is formed to connect the suction hole 32 and the vacuum source 20. In addition, a base end of the horn portion 26 is mechanically connected to an ultrasonic oscillator 16.

The ultrasonic generator 14 generates ultrasonic oscillation and includes, for example, the ultrasonic oscillator 16 and an AC power supply 18. The ultrasonic oscillator 16 is an oscillation generation source that generates longitudinal oscillation in response to receiving a drive signal, which is a voltage signal. This ultrasonic oscillator 16 has, for example, lead zirconate titanate (commonly called PZT) that vibrates in response to an alternating voltage, and is a bolt-clamped Langevin transducer (commonly called BLT or BL transducer) in which PZT is sandwiched between metal blocks and clamping pressure is applied with screws (bolts). The AC power supply 18 applies an alternating voltage having a frequency corresponding to a predetermined resonance frequency to this ultrasonic oscillator 16.

By driving the ultrasonic generator 14, the holding surface 24 ultrasonically oscillates in the axial direction. Then, as the holding surface 24 ultrasonically oscillates, an ultrasonic squeeze effect occurs between the holding surface 24 and a plane closely opposing the holding surface 24 (for example, an end surface of the semiconductor chip 100), whereby the semiconductor chip 100 is held on the holding surface 24 while remaining separated from the holding surface 24.

The vacuum source 20 generates negative pressure and includes, for example, an air pump, etc. The vacuum source 20 communicates with the suction path 33, and by driving the vacuum source 20, negative pressure acts on the suction hole 32, which generates a suction force that attracts the semiconductor chip 100 to the holding surface 24.

The controller 22 controls driving of the above-described ultrasonic generator 14 and vacuum source 20. This controller 22 is physically a computer having a processor 22a and a memory 22b. "Computer" also includes a microcontroller in which a computer system is incorporated into a single integrated circuit. In addition, the processor 22a refers to a processor in a broad sense, and includes a general-purpose processor (for example, CPU: Central Processing Unit, etc.) and a dedicated processor (for example, GPU: Graphics Processing Unit, ASIC: Application Specific Integrated Circuit, FPGA: Field Programmable Gate Array, programmable logic device, etc.). Further, the memory 22b may include at least one of a semiconductor memory (for example, RAM, ROM, solid state drive, etc.) and a magnetic disk (for example, hard disk drive, etc.). And, neither the processor 22a nor the memory 22b needs to be single, and the controller 22 may have multiple processors 22a and multiple memories 22b.

This controller 22 controls driving of the ultrasonic generator 14 and the vacuum source 20 so that the holding surface 24 can hold the semiconductor chip 100 in a non-contact manner. That is, as described above, in response to an alternating voltage being applied to the ultrasonic oscillator 16, the holding surface 24 ultrasonically oscillates. In the case of bringing the semiconductor chip 100 close to the holding surface 24 while ultrasonic oscillation is generated, an ultrasonic squeeze effect is generated between the holding surface 24 and the semiconductor chip 100. The ultrasonic squeeze effect is an effect that, in the case of oscillating one of two flat plates opposing each other via a minute gap, the influence of viscosity within the gap causes pressure higher than external pressure to be generated within the gap. In response to occurrence of this ultrasonic squeeze effect, an air film Sf that inhibits contact is formed between the semiconductor chip 100 and the holding surface 24, and a holding force that holds the semiconductor chip 100 on the holding surface 24 is generated.

Here, the holding force generated by the ultrasonic squeeze effect (hereinafter referred to as "ultrasonic holding force") occurs in both directions perpendicular to and parallel to the holding surface 24 (that is, surface direction). That is, in the case of occurrence of the ultrasonic squeeze effect, a force in a direction that separates the semiconductor chip 100 from the holding surface 24 or causes the semiconductor chip 100 to float from the holding surface 24 acts on the semiconductor chip 100. Additionally, in the case of occurrence of the ultrasonic squeeze effect, the semiconductor chip 100 tends to remain within the oscillation plane. Therefore, even if the position of the semiconductor chip 100 temporarily deviates in the surface direction due to an external force, the semiconductor chip 100 moves in the surface direction so that the entire semiconductor chip 100 is positioned within the oscillation plane, and tends to return to a state of directly facing the holding surface 24.

The thickness of the air film generated by the ultrasonic squeeze effect (hereinafter referred to as "ultrasonic squeeze film Sf"), that is, the floating amount Df of the semiconductor chip 100 from the holding surface 24, increases as the ultrasonic energy increases (that is, as the amplitude of ultrasonic oscillation increases). The ultrasonic holding force also increases as the ultrasonic energy increases.

**In** this example, in order to assist such an ultrasonic holding force, a suction force is further generated on the holding surface 24 by negative pressure. The controller 22 controls driving of the vacuum source 20 and the ultrasonic generator 14 so that the suction force, the ultrasonic holding force, and the gravity acting on the semiconductor chip 100 are balanced in a state where the semiconductor chip 100 floats from the holding surface 24.

As described above, the semiconductor chip 100 tends to be positioned within the oscillation plane in response to the ultrasonic squeeze effect. Therefore, by forming the holding surface 24 into substantially the same shape as the semiconductor chip 100, the semiconductor chip 100 automatically moves in the surface direction due to the ultrasonic squeeze effect so that the entire semiconductor chip 100 is positioned within the oscillation plane (that is, within an area inside the outer shape of the holding surface 24). In other words, self alignment of the semiconductor chip 100 in the surface direction becomes possible.

However, such a holding force in the surface direction resulting from the ultrasonic squeeze effect is not very large. Therefore, depending on how strong the gravity or inertial force acting on the semiconductor chip 100 is, the semiconductor chip 100 may not be positioned with sufficient accuracy in the surface direction. Thus, in order to further improve the positioning accuracy of the semiconductor chip 100 in the surface direction, in this example, the holding surface 24 is made larger than the semiconductor chip 100, and multiple grooves 34 and 36 are formed on the holding surface 24. This will be described in detail below.

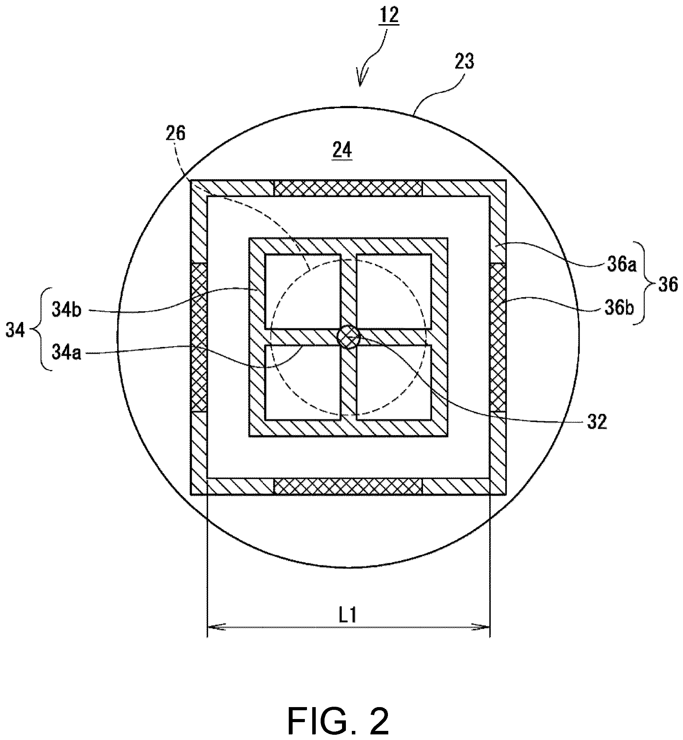

FIG. 2 is an axial view of the holding surface 24. In FIG. 2, diagonal hatching portions indicate recess portions that do not penetrate through the holding portion 23, and cross hatching portions indicate hole portions that penetrate through the holding portion 23. As shown in FIG. 2, the suction hole 32, the airflow formation groove 34, and the positioning groove 36 are formed on the holding surface 24. The positioning groove 36 has substantially the same shape as the outer shape of the semiconductor chip 100. In the case of this example, since the semiconductor chip 100 is a square with one side of approximately L1, the shape of the inner peripheral edge of the positioning groove 36 is also a square with one side of approximately L1. As described above, the holding surface 24 is roughly divided into a central portion 28 that overlaps with the horn portion 26 and a flange portion 30 that extends radially outward from the central portion 28, and the positioning groove 36 is positioned in this flange portion 30. At least a portion of the positioning groove 36 is a recess portion 36a that is sufficiently shallower than the thickness of the flange portion 30, and the remainder of the positioning groove 36 is a hole portion 36b that penetrates through the flange portion 30 in the thickness direction. In the example of FIG. 2, among the positioning groove 36, the rectangular straight portions penetrate through the flange portion 30 in the thickness direction, and the rectangular corner portions are recess portions that do not penetrate through the flange portion 30.

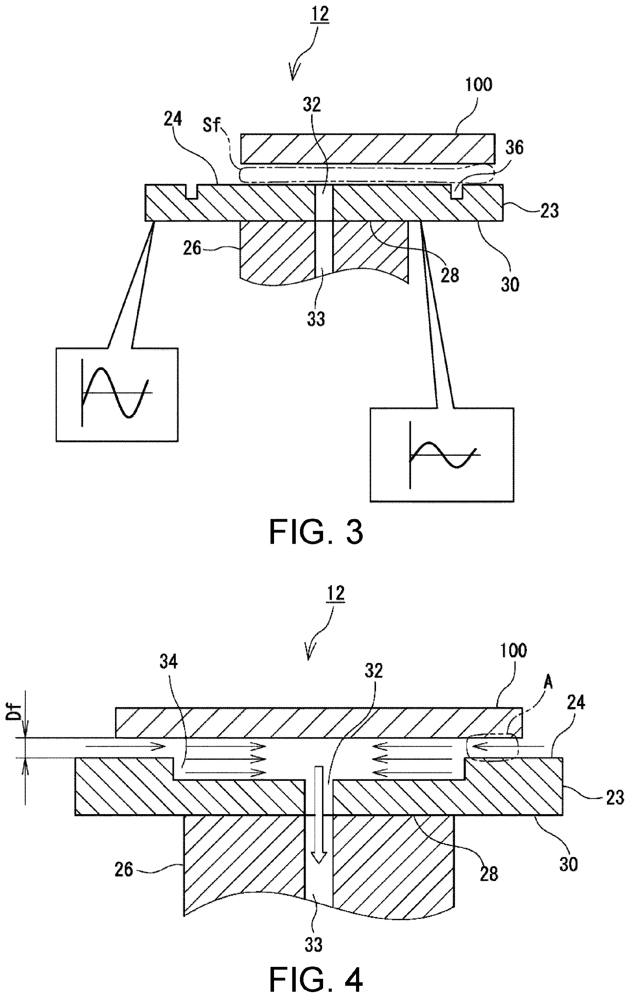

The action of such a positioning groove 36 will be described with reference to FIG. 3. FIG. 3 is an image view showing the action of the positioning groove 36. In FIG. 3, illustration of the airflow formation groove 34 is omitted. In the case of forming the positioning groove 36, the positioning accuracy of the semiconductor chip 100 in the surface direction is improved compared to the case of not forming the positioning groove 36. The principle by which such action is obtained is presumed to be that the amplitude of ultrasonic oscillation changes abruptly at the boundary of the positioning groove 36.

That is, in the case of driving the ultrasonic generator 14, ultrasonic oscillation occurs on the holding surface 24. It is considered that the amplitude of the ultrasonic oscillation gradually increases toward the outer peripheral edge of the holding surface 24 in the case of no positioning groove 36. Since the ultrasonic holding force changes according to the amplitude of ultrasonic oscillation, even without the positioning groove 36, the ultrasonic holding force acting on the semiconductor chip 100 becomes unbalanced between left and right in the case of the semiconductor chip 100 being displaced from the center of the holding surface 24 in the surface direction. The semiconductor chip 100 moves in the surface direction to resolve this force imbalance, so the positional deviation of the semiconductor chip 100 in the surface direction is automatically corrected, that is, self alignment is performed. However, in the case of no positioning groove 36, the imbalance of ultrasonic holding force caused by the positional deviation of the semiconductor chip 100 is minute, and therefore the force of self alignment is small.

On the other hand, in the case where the positioning groove 36 is formed, the strength of the holding surface 24 locally decreases at the location where the positioning groove 36 is formed. In response to ultrasonic oscillation being applied to such a holding surface 24, the outer portion with respect to the positioning groove 36 becomes easy to swing with the positioning groove 36 as a fulcrum. As a result, the outer portion has a more rapidly increasing oscillation amplitude compared to the inner portion with respect to the positioning groove 36, and the ultrasonic holding force changes abruptly at the boundary of the positioning groove 36.

Therefore, as shown in FIG. 3, in the case of one end of the semiconductor chip 100 in the surface direction being positioned radially outward beyond the positioning groove 36, the left-right balance of the ultrasonic holding force is significantly disrupted. A relatively large force acts on the semiconductor chip 100 to resolve such imbalance, and the semiconductor chip 100 moves to the inside of the positioning groove 36. Thus, compared to the case of no positioning groove 36, the case of forming the positioning groove 36 can improve the accuracy of self alignment of the semiconductor chip 100.

Next, the airflow formation groove 34 will be described. As shown in FIG. 2, the suction hole 32 is formed at the center of the holding surface 24, and this suction hole 32 communicates with the vacuum source 20. The airflow formation groove 34 is a groove connected to this vacuum source 20. The shape of this airflow formation groove 34 is not particularly limited as long as the airflow formation groove 34 connects to the suction hole 32. In this example, the airflow formation groove 34 includes four radial portions 34a that extend radially or in a cross shape from the suction hole 32, and a peripheral portion 34b that directly connects to the radial portions 34a while not passing through the suction hole 32. As shown in FIG. 2, the peripheral portion 34b has a closed shape surrounding the suction hole 32, more specifically, a substantially rectangular shape, so as to connect all of one or more radial portions 34a. Such an airflow formation groove 34 is formed only in an area that is inside the positioning groove 36, in other words, inside the outer shape of the semiconductor chip 100, as shown in FIG. 2.

The action of such an airflow formation groove 34 will be described with reference to FIG. 4. FIG. 4 is an image view showing the action of the airflow formation groove 34. In FIG. 4, the illustration of the positioning groove 36 is omitted. In the case of forming the airflow formation groove 34, the positioning accuracy of the semiconductor chip 100 in the surface direction is improved compared to the case of not forming the airflow formation groove 34. The principle by which such action is obtained is presumed to be that formation of the airflow formation groove 34 accelerates and stabilizes the surface direction airflow flowing between the semiconductor chip 100 and the holding surface 24.

That is, in the case of generating a suction force by the vacuum source 20 while floating the semiconductor chip 100 by the ultrasonic squeeze effect, an airflow in the surface direction and toward the center is generated in the floating gap. Here, without the airflow formation groove 34, the surface direction airflow toward the center is affected by fluid viscosity, has low velocity, and tends to become unstable. Besides, the suction force acts locally only in the vicinity of the suction hole 32. In this case, even with positional deviation in the surface direction, it is difficult for the semiconductor chip 100 to move in the surface direction, and perform self correction of the positional deviation.

On the other hand, as shown in FIG. 4, in the case of forming the airflow formation groove 34, the thickness of the gap between the semiconductor chip 100 and the holding surface 24 becomes large in the vicinity of the airflow formation groove 34, and the influence of fluid viscosity acting on the entire airflow is reduced. As a result, the velocity of the surface direction airflow increases, and the surface direction airflow is stabilized. In particular, the airflow in the vicinity of the outer periphery of the semiconductor chip 100 (near region A in FIG. 4) can be significantly stabilized compared to the case of no airflow formation groove 34. Such a stable airflow in the surface direction applies a force to the semiconductor chip 100 to make the center of the semiconductor chip 100 approach the suction hole 32 (and thus the center of the holding surface 24). Thereby, the semiconductor chip 100 is automatically positioned with respect to the holding surface 24. Also, by forming the airflow formation groove 34, the peak of the suction force generated near the suction hole 32 can be reduced, and the suction force can be dispersed in the surface direction. This makes it easy for the semiconductor chip 100 to move in the surface direction, and perform self correction of positional deviation in the surface direction.

The depth of such an airflow formation groove 34 is not particularly limited. However, in the case of the airflow formation groove 34 being excessively shallow, the flow velocity of the surface direction airflow in the floating gap becomes small due to the influence of fluid viscosity. Therefore, the depth of the airflow formation groove 34 may be equal to or greater than the floating amount Df of the semiconductor chip 100 from the holding surface 24. Further, in the case of the airflow formation groove 34 being excessively deep, the airflow formation groove 34 affects the oscillation mode and oscillation amplitude of the holding surface 24. Therefore, the airflow formation groove 34 has a size that does not affect the oscillation mode and oscillation amplitude of the holding surface 24. For example, the airflow formation groove 34 may be less than 100 times, or less than 50 times, or less than 10 times the floating amount Df.

As is clear from the above description, according to this example, the positional accuracy in automatic positioning of the semiconductor chip 100, so-called self alignment, can be further improved. Nevertheless, the description so far is an example, and other configurations may be appropriately changed as long as the size of the outer shape of the holding surface 24 is larger than the size of the outer shape of the semiconductor chip 100, or the airflow formation groove 34 connecting to the suction hole 32 is formed on the holding surface 24.

Accordingly, in the case of the size of the outer shape of the holding surface 24 being larger than the size of the outer shape of the semiconductor chip 100, no groove may be formed on the holding surface 24. In addition, in the case of the airflow formation groove 34 being formed on the holding surface 24, the size of the outer shape of the holding surface 24 may be the same as or smaller than the size of the outer shape of the semiconductor chip 100.

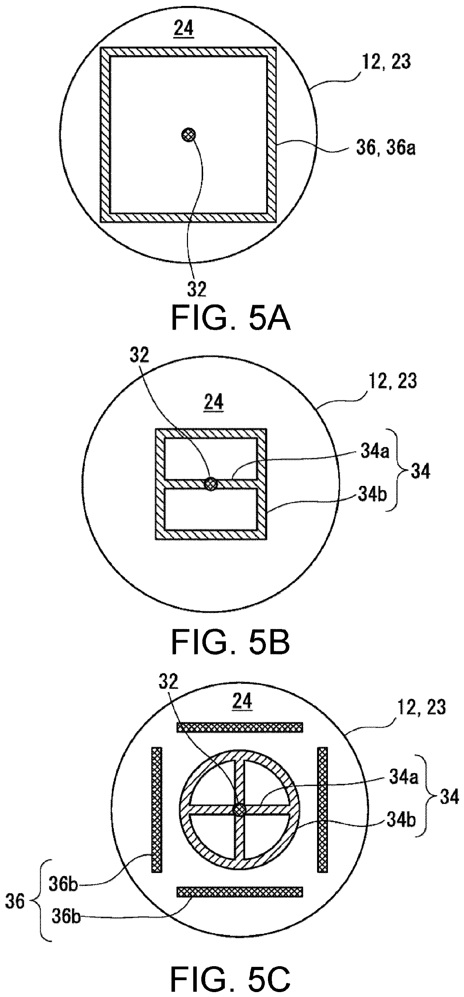

Furthermore, the shapes and combinations of the positioning groove 36 and the airflow formation groove 34 may be appropriately changed. For example, as shown in FIG. 5A, only the positioning groove 36 may be formed on the holding surface 24, and the airflow formation groove 34 may not be formed. Additionally, the position and range of the hole portion (cross hatching portion) of the positioning groove 36 that penetrates through the flange portion 30 may be appropriately changed. For example, as shown in FIG. 5A, the positioning groove 36 may not have a hole portion. Also, the shape of the positioning groove 36 does not need to be a closed curve that has no start end or terminal end, and may be one or more open curve shapes, as shown in FIG. 5C. In this case, the entirety of the positioning groove 36 may be a hole portion (cross hatching portion) that penetrates through the flange portion 30 in the thickness direction.

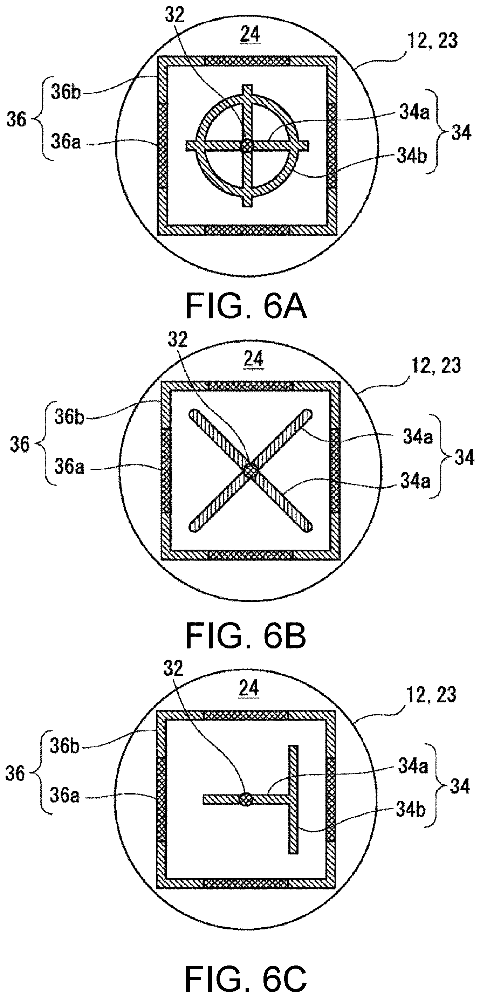

In addition, as shown in FIG. 5B, only the airflow formation groove 34 may be formed on the holding surface 24, and the positioning groove 36 may not be formed. Further, in the case of the airflow formation groove 34 connecting to the suction hole 32, the shape thereof may also be appropriately changed. For example, the number of radial portions 34a constituting the airflow formation groove 34 is not limited, and may be fewer than four or more than four. Accordingly, for example, the airflow formation groove 34 may have two radial portions 34a, as shown in FIG. 5B, and may have a shape like the digital number "8" as a whole. Also, the peripheral portion 34b of the airflow formation groove 34 is not necessarily rectangular, and may be circular, as shown in FIG. 5C. Besides, the radial portion 34a may extend beyond the peripheral portion 34b to the outside, as shown in FIG. 6A. Furthermore, as shown in FIG. 6B, the airflow formation groove 34 may have a shape having only the radial portion 34a extending from the suction hole 32 in the surface direction and having no peripheral portion 34b. Furthermore, the peripheral portion 34b does not need to be a closed shape connecting all of one or more radial portions 34a, and may be a line segment having end portions. Accordingly, for example, the airflow formation groove 34 may have a shape like "H". Furthermore, the airflow formation groove 34 may have a shape like "T" having a linear radial portion 34a parallel to the positioning groove 36 and peripheral portions 34b extending linearly in both lateral directions from the end portion of the radial portion 34a, as shown in FIG. 6C.

Nevertheless, as described above, the chip holding tool 12 of this example is movable and rotatable, and can change in posture and position. The controller 22 changes the ultrasonic energy and suction force applied to the holding surface 24 according to such movement and posture change of the chip holding tool 12.

That is, according to the movement of the holding surface 24, the direction and magnitude of the inertial force acting on the semiconductor chip 100 change. The controller 22 adjusts the ultrasonic energy and suction force so that the semiconductor chip 100 can be held in a non-contact manner even in the case of such changes in the direction and magnitude of the inertial force. Specifically, in the case of the holding surface 24 moving, the controller 22 increases at least one of the ultrasonic energy and the suction force compared to the case of the holding surface 24 being stationary.

For example, it is assumed that the holding surface 24 moves in the surface direction thereof (for example, the direction of arrow A1 in FIG. 1). In this case, an inertial force acts on the semiconductor chip 100 in the surface direction and in the direction opposite to the movement direction. In order to maintain the state of holding the semiconductor chip 100 against this inertial force, the controller 22 adjusts the ultrasonic energy and suction force so that the holding force in the surface direction of the semiconductor chip 100 increases. Specifically, the controller 22 may increase the suction force so that the holding force in the surface direction increases while keeping the ultrasonic energy constant. Additionally, as another form, the controller 22 may increase the ultrasonic energy so that the holding force in the surface direction increases while keeping the suction force constant.

Further, it is assumed that the chip holding tool 12 moves in the axial direction thereof and in the direction approaching the semiconductor chip 100 (for example, the direction of arrow A2 in FIG. 1). In this case, the semiconductor chip 100 approaches the holding surface 24 due to the inertial force, and there is a risk that the thickness of the ultrasonic squeeze film Sf between the semiconductor chip 100 and the holding surface 24 may decrease. Therefore, in this case, the ultrasonic energy may be increased to prevent the thickness of the ultrasonic squeeze film Sf from decreasing.

Additionally, it is assumed that the chip holding tool 12 moves in the axial direction thereof and in the direction away from the semiconductor chip 100 (for example, the direction of arrow A3 in FIG. 1). In this case, the semiconductor chip 100 moves away from the holding surface 24 due to the inertial force, and there is a risk that the holding force of the semiconductor chip 100 provided by the holding surface 24 may decrease. Therefore, in this case, in order to prevent a decrease in the holding force, the suction force or the ultrasonic energy may be increased.

The influence that gravity exerts on the semiconductor chip 100 also changes according to the posture of the chip holding tool 12. For example, in the case of the chip holding tool 12 facing upward, the gravity acting on the semiconductor chip 100 acts as a force that brings the semiconductor chip 100 close to the holding surface 24. On the other hand, in the case of the chip holding tool 12 facing downward, the gravity acting on the semiconductor chip 100 acts as a force that separates the semiconductor chip 100 from the holding surface 24. Therefore, in the case of the chip holding tool 12 facing downward, the controller 22 may increase at least one of the ultrasonic energy and the suction force so that the holding force provided by the holding surface 24 increases, compared to the case of the chip holding tool 12 facing upward.

In addition, in the case of the chip holding tool 12 facing sideways, the gravity acting on the semiconductor chip 100 acts as a force that moves the semiconductor chip 100 in the surface direction, that is, a force that causes positional deviation of the semiconductor chip 100 in the surface direction. Therefore, in the case of the chip holding tool 12 facing sideways, the controller 22 may increase the ultrasonic energy so that the holding force in the surface direction provided by the holding surface 24 increases, compared to the case of the chip holding tool 12 facing upward or downward.

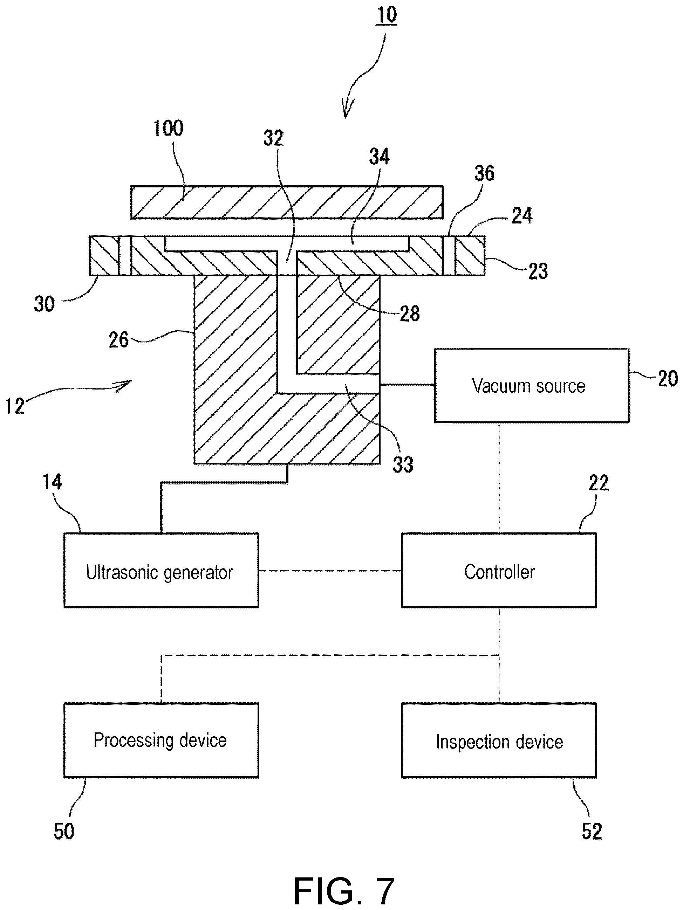

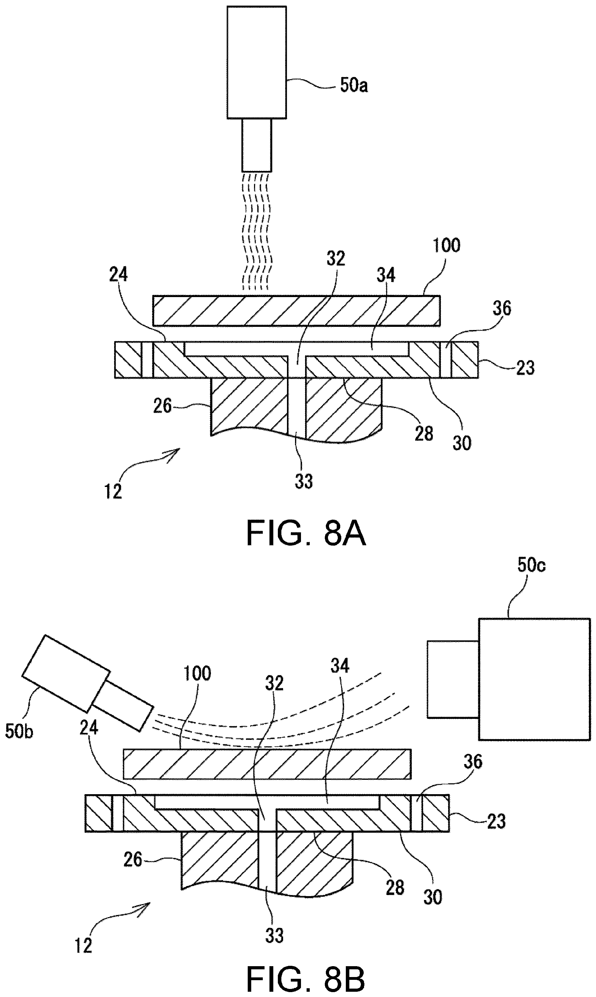

Next, another chip holding device 10 will be described with reference to FIG. 7. FIG. 7 is a view showing the configuration of another chip holding device 10. This chip holding device 10 further includes a processing device 50 and an inspection device 52 in addition to the chip holding device 10 of FIG. 1. The processing device 50 is a device that applies predetermined processing, for example, a plasma process or a cleaning process, to the surface of the semiconductor chip 100 held in a non-contact manner by the chip holding tool 12. FIG. 8A and FIG. 8B show an example of such a processing device 50. FIG. 8A shows that the processing device 50 that applies a plasma process includes a plasma irradiation head 50a. As shown in FIG. 8A, the plasma irradiation head 50a can irradiate plasma to the surface of the semiconductor chip 100 on the opposite side from the holding surface 24, and apply a plasma process to the surface on the opposite side. Further, FIG. 8B shows that the processing device that applies a cleaning process to the surface of the semiconductor chip 100 includes an air blow 50b that removes foreign matter and a suction duct 50c that collects the blown-away foreign matter. According to such a processing device 50, foreign matter adhering to the surface of the semiconductor chip 100 can be removed.

And, as is clear from FIG. 8A and FIG. 8B, according to this example, such surface processing (plasma process, cleaning process, etc.) can be performed while the semiconductor chip 100 is floating. As a result, deterioration and contamination of the semiconductor chip 100 can be effectively prevented.

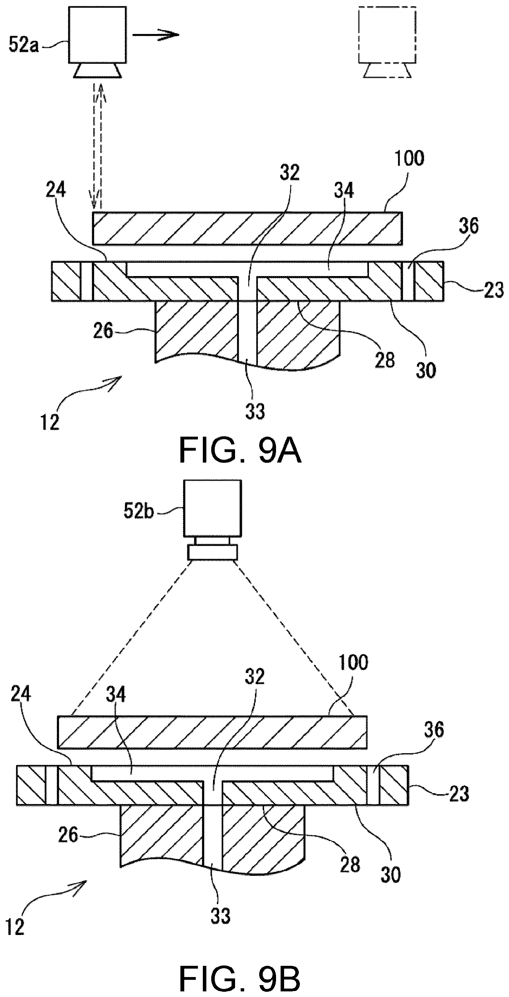

The inspection device 52 is a device that inspects the semiconductor chip 100 held in a non-contact manner by the chip holding tool 12. FIG. 9A and FIG. 9B show an example of such an inspection device 52. FIG. 9A shows that the inspection device 52 that inspects the edge of the semiconductor chip 100 includes a laser displacement meter 52a. The laser displacement meter 52a irradiates a laser to an object and detects the distance to the object and the presence or absence of the object based on the reflected light. By scanning such a laser displacement meter 52a in the surface direction of the semiconductor chip 100, the position of the edge of the semiconductor chip 100 can be detected.

Further, FIG. 9B shows that the inspection device 52 that inspects the appearance of the semiconductor chip 100 includes an inspection camera 52b. The inspection camera 52b captures an image of the surface of the semiconductor chip 100 on the opposite side from the holding surface 24. The controller 22 determines the quality, etc. of the semiconductor chip 100 based on the obtained image.

And, as is clear from FIG. 9A and FIG. 9B, according to this example, such inspection of the semiconductor chip 100 (edge inspection and appearance inspection) can be performed while the semiconductor chip 100 is floating. As a result, deterioration and contamination of the semiconductor chip 100 can be effectively prevented. In the case of floating the semiconductor chip 100 using the ultrasonic squeeze effect, the semiconductor chip 100 oscillates minutely in the axial direction. The amplitude of this minute oscillation of the semiconductor chip 100 is reduced more by releasing the suction than during execution of suction of the vacuum source 20. Therefore, in order to reduce the influence of such minute oscillation on inspection accuracy, during the inspection execution period, the driving of the vacuum source 20 may be stopped to eliminate the suction force. Furthermore, as another form, in order to reduce the influence of minute oscillation on inspection accuracy, the timing of sampling inspection values performed by the inspection device 52 may be synchronized with the oscillation cycle of the semiconductor chip 100.

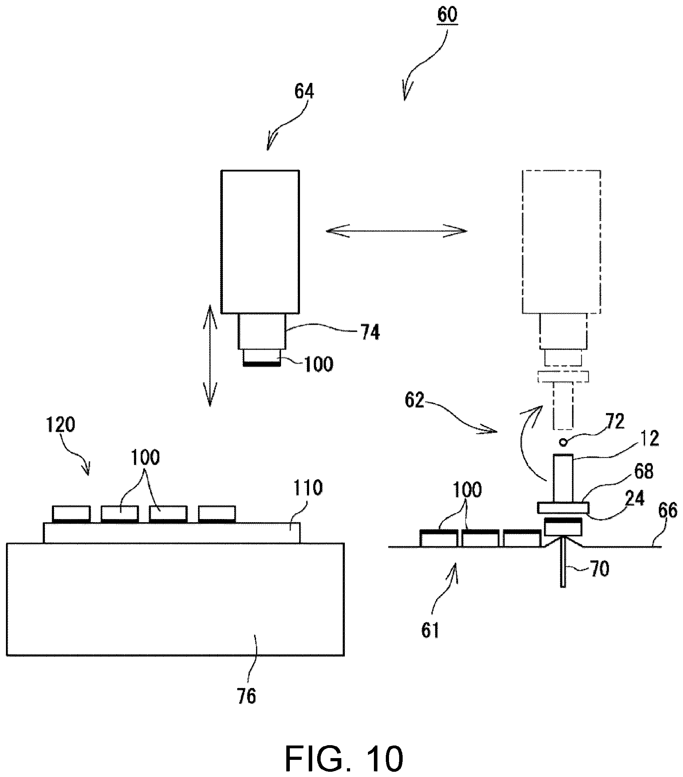

In addition, the chip holding device 10 described so far may be incorporated into, for example, a manufacturing device for semiconductor devices. FIG. 10 is a view showing an example of a manufacturing device 60 having the chip holding device 10. The manufacturing device 60 in FIG. 10 is a device that manufactures a semiconductor device by bonding one or more semiconductor chips 100 to a substrate 110.

This manufacturing device 60 includes a chip supply source 61, a pickup part 62, and a bonding part 64. In the chip supply source 61, semiconductor chips 100 attached to a dicing tape 66 are prepared. The pickup part 62 includes a push-up pin 70 that pushes up the semiconductor chip 100 attached to the dicing tape 66 from below, and a pickup collet 68 that picks up the pushed-up semiconductor chip 100. In this example, the above-described chip holding device 10 is used as this pickup collet 68.

The semiconductor chip 100 is attached to the dicing tape 66 in a posture with the surface to be bonded to the substrate 110, that is, the bonding surface (thick line portion in FIG. 10), facing upward. The chip holding tool 12 of the pickup collet 68 holds this bonding surface in a non-contact manner with the holding surface 24. In other words, since the bonding surface is not in contact with the holding surface 24, adhesion of foreign matter is prevented, and chipping due to impact during contact is effectively prevented as well.

In response to receiving the semiconductor chip 100 from the dicing tape 66, the pickup collet 68 rotates 180 degrees around a specified rotation axis 72. Thus, the holding surface 24 changes from a downward-facing state to an upward-facing state. The controller 22 increases at least one of the ultrasonic energy and the suction force during the rotational movement, compared to the stationary state, so that the semiconductor chip 100 can be appropriately held during the rotational movement.

The bonding part 64 includes a bonding stage 76 on which the substrate 110 is placed, and a bonding tool 74 that holds and transports the semiconductor chip 100. The bonding tool 74 holds the semiconductor chip 100 by suction at the end surface thereof and transports the semiconductor chip 100. As shown in FIG. 10, this bonding tool 74 receives the semiconductor chip 100 from the pickup collet 68 in an upward posture, and holds by suction the surface opposite to the bonding surface of the semiconductor chip 100. Further, the bonding tool 74 presses the semiconductor chip 100 against the substrate 110 and bonds the semiconductor chip 100 to the substrate 110. By bonding the required number of semiconductor chips 100 to one substrate 110, a semiconductor device 120 is manufactured.

Here, the form of this bonding is not particularly limited, but in this example, the semiconductor chip 100 is directly bonded to the substrate 110. Direct bonding is a bonding form in which the semiconductor chip 100 is directly bonded to the substrate 110 without using an adhesive. For example, in direct bonding, chip-side electrodes formed on the bonding surface of the semiconductor chip 100 are bonded to substrate-side electrodes formed on the substrate 110. At this time, the electrodes may be welded using heat, or may be bonded at room temperature.

Such direct bonding is susceptible to the influence of foreign matter or chipping on the bonding surface, and bonding defects are likely to occur in the case of even slight foreign matter or chipping. The pickup collet 68 of this example holds the semiconductor chip 100 in a non-contact manner, and the bonding surface of the semiconductor chip 100 does not come into contact with other members until the semiconductor chip 100 is bonded to the substrate 110. Therefore, according to this example, adhesion of foreign matter to the bonding surface and occurrence of chipping can be effectively prevented, and thereby bonding defects in direct bonding can be effectively prevented.

The configuration described here is an example, and other configurations may be appropriately changed as long as the manufacturing device 60 has the chip holding device 10 that holds the semiconductor chip 100 in a non-contact manner. For example, the manufacturing device 60 may bond the semiconductor chip 100 to the substrate 110 using an adhesive such as NCF. In addition, the chip holding device 10 may be used not only for the pickup collet 68 but also for the bonding tool 74.

### Description of Reference Numerals

10 chip holding device, 12 chip holding tool, 14 ultrasonic generator, 16 ultrasonic oscillator, 18 AC power supply, 20 vacuum source, 22 controller, 23 holding portion, 24 holding surface, 26 horn portion, 28 central portion, 30 flange portion, 32 suction hole, 33 suction path, 34 airflow formation groove, 36 positioning groove, 50 processing device, 50a plasma irradiation head, 50b air blow, 50c suction duct, 52 inspection device, 52a laser displacement meter, 52b inspection camera, 60 manufacturing device, 61 chip supply source, 62 pickup part, 64 bonding part, 66 dicing tape, 68 pickup collet, 70 push-up pin, 72 rotation axis, 74 bonding tool, 76 bonding stage, 100 semiconductor chip, 110 substrate, 120 semiconductor device.

## Claims

1. A chip holding tool, comprising:
a holding surface holding a semiconductor chip in a non-contact manner;
a suction path applying negative pressure to the holding surface to draw the semiconductor chip by suction; and
an oscillation generation part applying ultrasonic oscillation to the holding surface, wherein
a size of an outer shape of the holding surface is larger than a size of an outer shape of the semiconductor chip.

2. The chip holding tool according to claim 1, wherein
a positioning groove having a shape conforming to at least a portion of the outer shape of the semiconductor chip is formed on the holding surface.

3. The chip holding tool according to claim 2, wherein
the oscillation generation part comprises a horn portion that transmits ultrasonic oscillation,
the chip holding tool further comprises a plate-shaped holding portion which is connected to an end of the horn portion, and an end surface of which functions as the holding surface, and
the holding portion comprises:
a central portion that overlaps with the horn portion in an axial direction; and
a flange portion that extends radially outward from the central portion and is thinner than the central portion.

4. The chip holding tool according to claim 3, wherein
at least a portion of the positioning groove penetrates through the flange portion in a thickness direction.

5. The chip holding tool according to any one of claims 2 to 4, wherein
in a case of applying ultrasonic oscillation to the holding surface, an oscillation amplitude of an outer portion with respect to the positioning groove is greater than an oscillation amplitude of an inner portion with respect to the positioning groove.

6. The chip holding tool according to any one of claims 2 to 5, wherein
the semiconductor chip is self-aligned to be positioned inside the positioning groove by receiving the oscillation amplitude of the outer portion with respect to the positioning groove.

7. A chip holding tool, comprising:
a holding surface holding a semiconductor chip in a non-contact manner;
a suction path applying negative pressure to the holding surface to draw the semiconductor chip by suction; and
an oscillation generation part applying ultrasonic oscillation to the holding surface, wherein
the suction path has a suction hole formed on the holding surface and communicating with a suction source, and
the holding surface is formed with an airflow formation groove that connects to the suction hole and extends in a surface direction.

8. The chip holding tool according to claim 7, wherein
the airflow formation groove is formed only in an area that is inside an outer shape of the semiconductor chip.

9. The chip holding tool according to claim 8, wherein
the airflow formation groove comprises one or more radial portions that extend in a surface direction from the suction hole.

10. The chip holding tool according to claim 9, wherein
the airflow formation groove further comprises one or more peripheral portions that directly connect to the radial portion while not passing through the suction hole.

11. The chip holding tool according to claim 10, wherein
the peripheral portion is a closed shape that surrounds the suction hole and connects all of the one or more radial portions.

12. The chip holding tool according to claim 8, wherein
a depth of the airflow formation groove is greater than a floating amount of the semiconductor chip from the holding surface and less than 50 times the floating amount.

13. A chip holding device, for holding a semiconductor chip in a non-contact manner, the chip holding device comprising:
a chip holding tool holding the semiconductor chip in a non-contact manner;
an ultrasonic generation part applying ultrasonic oscillation to a holding surface that is an end surface of the holding tool;
a suction path applying negative pressure to a suction hole formed on the holding surface to generate a suction force; and
a controller controlling ultrasonic energy or the suction force so that a holding force generated by the ultrasonic oscillation, the suction force, and gravity acting on the semiconductor chip are balanced in a state where the semiconductor chip is separated from the holding surface.

14. The chip holding device according to claim 13, wherein
the controller changes a magnitude of at least one of the ultrasonic energy and the suction force applied to the holding surface between a case of moving a position of the holding surface and a case of keeping the position stationary.

15. The chip holding device according to claim 14, wherein
the controller increases at least one of the ultrasonic energy and the suction force in a case of moving the holding surface compared to a case of keeping the holding surface stationary.

16. A chip holding device, for holding a semiconductor chip in a non-contact manner, the chip holding device comprising:
a chip holding tool holding the semiconductor chip in a non-contact manner;
an ultrasonic generation part applying ultrasonic oscillation to a holding surface that is an end surface of the chip holding tool;
a suction path applying negative pressure to a suction hole formed on the holding surface to generate a suction force;
a controller controlling driving of the ultrasonic generation part and a suction source so that a holding force generated by the ultrasonic oscillation, the suction force, and gravity acting on the semiconductor chip are balanced in a state where the semiconductor chip is separated from the holding surface; and
at least one of a surface processing device that applies processing to a surface of the semiconductor chip held in a non-contact manner by the holding surface, and an inspection device that inspects the surface.

17. A device for manufacturing a semiconductor device, the device comprising:
a chip holding tool holding a semiconductor chip in a non-contact manner;
an ultrasonic generation part applying ultrasonic oscillation to a holding surface that is an end surface of the chip holding tool;
a suction path applying negative pressure to a suction hole formed on the holding surface to generate a suction force; and
a controller controlling driving of the ultrasonic generation part and a suction source so that a holding force generated by the ultrasonic oscillation, the suction force, and gravity acting on the semiconductor chip are balanced in a state where the semiconductor chip is separated from the holding surface, wherein
a size of an outer shape of the holding surface is larger than a size of an outer shape of the semiconductor chip.

18. The device for manufacturing the semiconductor device according to claim 17, wherein
the chip holding tool functions as a pickup collet that receives the semiconductor chip from a chip supply source, then flips 180 degrees while maintaining a state of holding the semiconductor chip in a non-contact manner, and transfers the semiconductor chip to a bonding tool.

19. The device for manufacturing the semiconductor device according to claim 17 or 18, wherein
the semiconductor chip is directly bonded to a substrate.
